# EUROPÄISCHE PATENTSCHRIFT

(11) **EP 0 962 828 B1**
(45) Veröffentlichungstag und Bekanntmachung des Hinweises auf die Patenterteilung: **23.10.2002**
(21) Anmeldenummer: 99110527.1
(22) Anmeldetag: 01.06.1999
(51) Int. Cl.: G03F 7/038, C08F 8/46

(54) **Herstellung vernetzbarer wasserlöslicher oder wasserdispergierbarer Zusammensetzungen und daraus erhältlicher strahlungsempfindlicher Gemische**
Production of water-soluble or water-dispersible compositions and light-sensitive materials containing such compositions
Production de compositions solubles ou dispersibles dans l'eau et matériaux photosensibles les contenant

(30) Priorität: 03.06.1998 DE 19824546
(43) Veröffentlichungstag der Anmeldung: 08.12.1999
(73) Patentinhaber: BASF Drucksysteme GmbH, 70469 Stuttgart (DE)
(72) Erfinder: Telser, Thomas Dr., 69469 Weinheim (DE); Stebani, Uwe Dr., 67592 Flörsheim-Dalsheim (DE); Leinenbach, Alfred, 67161 Gönnheim (DE); Tönnessen, Markus, 67069 Ludwigshafen (DE)
(74) Vertreter: Wicke, Reinhard

(56) Entgegenhaltungen:
- EP-A- 0 778 292
- US-A- 4 540 743

## Beschreibung

Die vorliegende Erfindung betrifft ein Verfahren zur Funktionalisierung eines wasserlöslichen oder in Wasser dispergierbaren polymeren Bindemittels, bei dem man ein unmodifiziertes, wasserlösliches oder in Wasser dispergierbares polymeres Bindemittel mit einem oder mehreren polaren aprotischen Quellungsmitteln, die mit dem Bindemittel verträglich sind, unter intensiver Vermischung mit einer oder mehreren Verbindungen, die radikalisch polymerisierbare Gruppen aufweisen, umsetzt.

Sie betrifft weiterhin eine Zusammensetzung, die im wesentlichen ein wasserlösliches oder in Wasser dispergierbares polymeres organisches Bindemittel mit radikalisch polymerisierbaren Gruppen sowie ein polares, aprotisches Quellungsmittel enthält, ein strahlungsempfindliches Gemisch, das als wesentliche Bestandteile die genannte Zusammensetzung, mindestens einen Photopolymerisationsinitiator, gegebenenfalls eine oder mehrere mit dem polymeren Bindemittel verträgliche, ethylenisch ungesättigte, photopolymerisierbare niedermolekulare Verbindungen, sowie weitere übliche Zusatz- und/oder Hilfsstoffe enthält. Sie betrifft ausserdem strahlungsempfindliche Hoch- oder Reliefdruckformen, die aus dem genannten strahlungsempfindlichen Gemisch hergestellt werden können.

An lichtempfindliche photopolymere Aufzeichnungsmaterialien, aus denen Druckformen oder Druckplatten hergestellt werden können, werden vielfältige Anforderungen gestellt. So sollten die Aufzeichnungsmaterialien eine hohe Lichtempfindlichkeit aufweisen, um ein scharfes Abbild des Filmes zu gewährleisten. Die belichteten Aufzeichnungsmaterialien sollen eine hohe mechanische Festigkeit aufweisen, um insbesondere bei Hochdruck- und Tiefdruckanwendungen hohe Auflagen ohne Beschädigung zu überstehen.

Lichtempfindliche Aufzeichnungsmaterialien auf der Basis von wasserauswaschbaren Polymeren und Monomeren für die Herstellung von Druck- und Reliefformen sind prinzipiell bekannt und bspw. von US 4,361,640, EP-A-079 514 oder EP-A-224 164 offenbart.

Es ist bekannt, als polymeres Bindemittel für wässrig entwickelbare Hochdruckplatten verschiedene Arten von Polyvinylalkohol einzusetzen, diese mit geeigneten Monomeren, Photoinitiator und Stabilisator abzumischen und aus der Lösung zu lichtempfindlichen Aufzeichnungsmaterialien zu vergießen.

Auf Grund der Polarität von Polyvinylalkohol können derartige Aufzeichnungsmaterialien nach der bildmäßigen Belichtung in kurzer Zeit in Wasser oder wäßriger Lösung ausgewaschen werden. Um eine ausreichende Lichtempfindlichkeit zu erzielen, müssen dem Polyvinylalkohol jedoch hohe Anteile an photopolymerisierbaren Monomeren, wie beispielsweise mono-, bi- oder multifunktionelle Acrylate oder Acrylamide zugesetzt werden. Derartige Monomere sind teuer, sind meist hautreizend und haben einen unangenehmen Geruch. Ferner haben Aufzeichnungsmaterialien aus Polyvinylalkohol, Monomeren und Photoinitiator eine ungenügende mechanische Kohäsion, was beim Druck zu Beschädigungen wie bspw. Rissen oder Kratzern führen kann.

Es ist deswegen vorgeschlagen worden, funktionalisierte Polyvinylalkohole einzusetzen, bei denen ein Teil der Hydroxylgruppen mit einem doppelbindungshaltigen Agens umgesetzt worden ist. Lichtempfindliche Aufzeichnungsmaterialien mit funktionalisiertem Polyvinylalkohol als polymerem Bindemittel haben den Vorteil, daß zu ihrer Vernetzung weniger Monomere zugesetzt werden müssen, kürzere Belichtungszeiten benötigt werden und die mechanische Beständigkeit im Vergleich zu Aufzeichnungsmaterialien mit unmodifiziertem Polyvinylalkohol deutlich verbessert wird.

Die Funktionalisierung von Polyvinylalkohol kann durch Umsetzung der Hydroxylgruppe mit ungesättigten Glycidylverbindungen, wie bspw. Glycidylmethacrylat, mit ungesättigten Anhydriden, wie bspw. Methacrylsäureanhydrid oder Maleinsäureanhydrid, oder mit ungesättigten Säuren durchgeführt werden. Bei der Durchführung der Umsetzung ergibt sich jedoch das Problem, daß Polyvinylalkohole nur in protischen Lösungsmitteln wie Wasser, Ethanol, Propanol löslich sind. Da die erwähnten Agentien mit Alkoholen oder Wasser aber schneller reagieren als die Hydroxylgruppen des Polyvinylalkohols, kann eine polymeranaloge Umsetzung in Lösung nicht realisiert werden.

Von EP-A-670 521 wird vorgeschlagen, die Umsetzung in der Schmelze durchzuführen. Diese Vorgehensweise ist jedoch nachteilig, da Polyvinylalkohol ohne Additive erst bei ca. 200°C schmilzt, wobei es schon zur Abspaltung von Wasser kommen kann. Auch die doppelbindungshaltigen Agentien neigen bei 200°C schon zur Zersetzung. Die erhaltenen, modifizierten Polymere müssen daher vor der Weiterverarbeitung zunächst durch Umfällen aus einem Gemisch von Wasser und organischen Lösungsmittel gereinigt werden.

In der WO 96/18133 wird ein Verfahren beschrieben, bei dem Polyvinylalkohol in wäßriger Lösung mit ungesättigten Aldehyden bzw. deren Acetalen umgesetzt wird. Da es sich bei der Umsetzung um eine säurekatalysierte Gleichgewichtsreaktion handelt, muß der Reaktionsmischung Säure zugesetzt werden oder die Mischung muß über einen sauren Ionenaustauscher geführt werden. Ferner sind nur wenige ungesättigte Verbindungen mit Aldehyd- bzw. Acetalfunktion kostengünstig kommerziell erhältlich.

In EP-A-079 514, DE-A-33 22 993 und DE-A-33 22 994 wird ein Verfahren beschrieben, in dem Polyvinylalkohol nach Aufschlämmen in Toluol oder halogenierten Kohlenwasserstoffen in einer heterogenen Reaktion mit Methacrylsäureanhydrid umgesetzt wird. Nachteilig bei diesem Verfahren ist, daß das zum Aufschlämmen benötigte organische Lösungsmittel nach erfolgter Reaktion aufwendig entfernt werden muß, da schon geringe Restanteile der organischen Lösemittel die Transparenz der Aufzeichnungsmaterialien verschlechtern. Da die Reaktion in heterogener Phase erfolgt, ist es weiterhin schwierig, eine homogene Funktionalisierung zu erreichen.

Aufgabe der vorliegenden Erfindung war es daher, ein einfaches und kostengünstiges Verfahren zur Funktionalisierung eines wasserlöslichen oder in Wasser dispergierbaren polymeren Bindemittels zu finden und aus den so erhältlichen Zusammensetzungen verbesserte lichtempfindliche Aufzeichnungsmaterialien bereitzustellen, die zur Herstellung von Hochdruckformen, Siebdruckbeschichtungsmaterialien und Folienprimern verwendet werden. Daneben sind die neuen Zusammensetzungen, enthaltend polare, aprotische Quellmittel, strahlungsempfindliche Gemische und diese enthaltende Hochdruckformen Gegenstand der Erfindung.

Dementsprechend wurde ein Verfahren zur Funktionalisierung eines wasserlöslichen oder in Wasser dispergierbaren polymeren organischen Bindemittels gefunden, bei dem man ein unmodifiziertes, wasserlösliches oder in Wasser dispergierbares polymeres Bindemittel mit einem oder mehreren polaren aprotischen Quellungsmitteln, die mit dem Bindemittel verträglich sind, unter intensiver Vermischung mit einer oder mehreren Verbindungen, die radikalisch polymerisierbare Gruppen aufweisen, umsetzt.

Überraschenderweise wurde gefunden, dass die erhaltene Zusammensetzung aus einem wasserlöslichen oder in Wasser dispergierbaren polymeren organischen Bindemittel mit radikalisch polymerisierbaren Gruppen und polaren, aprotischen Quellungsmitteln ohne Abtrennung des Quellungsmittels und ohne weitere Reinigung hervorragend zur Herstellung von strahlungsempfindlichen Gemischen geeignet ist.

Das gefundene strahlungsempfindliche Gemisch, enthält als wesentliche Bestandteile die obige Zusammensetzung, mindestens einen Photopolymerisationsinitiator sowie gegebenenfalls weitere übliche Zusatz- und/oder Hilfsstoffe. Weiterhin können ein oder mehrere mit dem polymeren Bindemittel verträgliche, ethylenisch ungesättigte, photopolymerisierbare niedermolekulare oder oligomere Verbindungen und/oder weitere wasserlösliche oder wasserdispergierbare Bindemittel enthalten sein. Schließlich wurden Hochoder Reliefdruckformen gefunden, die aus dem genannten strahlungsempfindlichen Gemisch hergestellt werden können.

Bei den als Ausgangsmaterial eingesetzten unmodifizierten wasserlöslichen oder in Wasser dispergierbaren polymeren Bindemitteln handelt es sich bevorzugt um Polyvinylalkohol oder Polyvinylalkohol-Copolymere. Unter den Begriff "Polyvinylalkohol" im Sinne dieser Erfindung sollen im folgenden teilverseifte Polyvinylacetate verstanden werden, deren Acetatgruppen zu mehr als 50% verseift sind. Der Verseifungsgrad wird einerseits durch die Bedingung der Wasserlöslichkeit bzw. Wasserdispergierbarkeit und andererseits durch die Höhe des gewünschten Umsetzungs- bzw. Funktionalisierungsgrades bestimmt. Bevorzugt beträgt der Verseifungsgrad 72 - 92%, ganz besonders bevorzugt 80 - 88%. Der mittlere Polymerisationsgrad liegt bevorzugt im Bereich zwischen 350 und 2500 und wird vom Fachmann auf diesem Gebiete entsprechend dem gewünschten Anwendungszweck gewählt. Weiterhin können Copolymere eingesetzt werden, die neben Vinylalkohol-/bzw. Vinylacetateinheiten andere Monomereinheiten enthalten. Als Comonomere kommen insbesondere α-Olefine wie Ethylen oder Propylen, Vinylverbindungen wie Acrylsäure, Methacrylsäure sowie deren Ester, Vinylamin oder Amide wie N-Vinylpyrrolidon und Vinylformamid in Frage. Es können auch Pfropf-Copolymere mit einer Seitenkette aus Polyvinylalkohol und einer Hauptkette bspw. aus Polyethylenoxid eingesetzt werden. Als Beispiel seien die in EP-A-224 164 offenbarten Bindemittel genannt.

Die Art und Menge an Comonomeren ist nur insofern beschränkt, als die Copolymere noch wasserlöslich oder in Wasser dispergierbar sein müssen. Es können auch Gemische von Polyvinylalkoholen oder Polyvinylalkohol-Copolymeren mit unterschiedlichem Polymerisationsgrad und/oder Verseifungsgrad eingesetzt werden.

Weiterhin sind einsetzbar wasserlösliche oder in Wasser dispergierbare polymere Bindemittel mit Carbonsäuregruppen, wie bspw. Polyacrylsäure und Polymethacrylsäure sowie Copolymere der genannten Säuren.

Ausserdem können Polymere mit Amin-Einheiten oder deren Copolymere eingesetzt werden, wie bspw. Polyvinylamin und Poly(vinylamin-vinylformamid)-Copolymere.

Als Quellungsmittel werden polare, aprotische Lösungsmittel eingesetzt. Die Auswahl ist nur insofern eingeschränkt, als sie mit den eingesetzten Polymeren verträglich sein müssen, d.h daß sie auf das Polymergranulat oder -pulver aufziehen, und zu einer Volumenzunahme (Quellung) der einzelnen Feststoffpartikel führen müssen. Bevorzugt sind organische Carbonate R₁O(CO)OR₂, wobei R₁ und R₂ jeweils für gradkettige oder verzweigte Alkylreste stehen, die auch noch inerte Substituenten, wie z.B. Chlor oder Brom tragen können. Gut geeignet sind insbesondere solche Carbonate mit 1 bis 6 Kohlenstoffatomen. R₁ und R₂ können auch zu einem z.B. 5-oder 6-gliedrigem Ring miteinander verbunden sein. Besonders bevorzugt sind Ethylencarbonat, Propylencarbonat, Butylencarbonat und Dimethylcarbonat. Es können auch Mischungen verschiedener Carbonate eingesetzt werden.

Weiterhin bevorzugt sind organische Phosphate R₁R₂R₃PO₄, wobei R₁,R₂ und R₃ jeweils für gradkettige oder verzweigte Alkylreste mit 1 bis 8 Kohlenstoffatomen stehen, die auch noch weiter substituiert sein können. R₁, R₂ und R₃ können auch paarweise zu einem Ring miteinander verbunden sein. Es können auch Mischungen verschiedener Phosphate eingesetzt werden. Aus Kostengründen besonders bevorzugt ist das Tris(2-Ethyl-hexyl)phosphat. Weiterhin können auch Mischungen der geschilderten organischen Carbonate und Phosphate eingesetzt werden.

Zur Funktionalisierung werden die unmodifizierten wasserlöslichen oder in Wasser dispergierbaren polymeren Bindemittel mit niedermolekularen Verbindungen, die sowohl vernetzbare Gruppen als auch Gruppen enthalten, die mit obigen Polymeren reagieren können, umgesetzt. Derartige Verbindungen und derartige Funktionalisierungsreaktionen sind prinzipiell bekannt, z.B. aus EP-A-079 514. Eingesetzt werden können bspw. Acylierungsmittel, die radikalisch polymerisierbare Gruppen eingebaut enthalten, und die mit Hydroxy- oder Amingruppen obiger Polymerer reagieren. Als Acylierungsmittel kommen dabei die üblichen, für Acylierungsreaktionen gebräuchlichen Verbindungsklassen in Frage, wie bspw. Carbonsäureester, Carbonsäurehalogenide und insbesondere Carbonsäureanhydride. Bei den in den Acylierungsmitteln enthaltenen radikalisch polymerisierbaren Gruppen handelt es sich üblicherweise um polymerisierbare ethylenische Doppelbindungen, die vorzugsweise aktiviert sind, d.h. in Konjugation zu anderen Doppelbindungen oder in Nachbarschaft zu Sauerstoff oder Stickstoffatomen stehen. Besonders vorteilhaft sind daher Acylierungsmittel, die sich von Maleinsäure, Acrylsäure oder Methacrylsäure ableiten, insbesondere Acrylsäureanhydrid und Methacrylsäureanhydrid. Es können auch Mischungen verschiedener Acylierungsmittel eingesetzt werden.

Weiterhin geeignet sind bspw. Epoxide, die zusätzlich radikalisch polymerisierbare Gruppen enthalten, wie Glycidylacrylat und Glycidylmethacrylat, die vorzugsweise mit Carboxylgruppen obiger Polymerer reagieren.

Die vorliegende Erfindung umfasst auch die Funktionalisierung durch eine Zweistufenreaktion, indem man z.B. die Hydroxygruppen oben genannter Polymerer zunächst mit einem cyclischen Carbonsäureanhydrid umsetzt und das erhaltene, carboxylgruppenhaltige Polymere weiter mit Glycidylacrylat umsetzt. Als cyclische Carbonsäureanhydride besonders geeignet sind Bernsteinsäureanhydrid, Glutarsäureanhydrid und Phthalsäureanhydrid.

Die Umsetzung kann ohne weitere Katalyse erfolgen. Sie kann aber auch durch Zugabe an sich bekannter Katalysatoren wie z.B. Methylimidazol oder Aminopyridinderivaten, die von DE-A-33 22 993 und DE-A-33 22 994 offenbart werden, beschleunigt werden.

Zur Stabilisierung gegen thermische Vernetzung kann der Polyvinylalkohol mit an sich bekannten Stabilisatoren versetzt werden. Gut geeignet sind z.B. Hydrochinonderivate, sterisch gehinderte Phenolderivate, Salze des Xyligens. Die Zugabe des Stabilisators kann vor oder nach erfolgter Funktionalisierung erfolgen.

Die Umsetzung der unmodifizierten wasserlöslichen oder in Wasser dispergierbaren polymeren Bindemittel mit den Funktionalisierungsagentien wird durchgeführt, indem man das polymere Bindemittel mit dem polaren, aprotischen Quellungsmittel, den Funktionalisierungsagentien und gegebenenfalls weiteren üblichen Zusatzstoffen oder Hilfsmitteln wie z.B. Katalysatoren oder Stabilisatoren versetzt und unter kräftiger Durchmischung umsetzt. Die Zugabe des Quellungsmittels kann vor oder gleichzeitig mit der Zugabe der Funktionalisierungsagentien und ggf. Zusatzstoffen und Hilfsmitteln erfolgen. Die Menge des eingesetzten Quellungsmittels kann prinzipiell beliebig gewählt werden. Bevorzugte Ausführungsform der vorliegenden Erfindung ist es aber, möglichst wenig Quellungsmittel einzusetzen, so dass ein gut rieselfähiges Produkt entsteht. Bevorzugt beträgt die Menge des Quellungsmittels 10 - 50 Gew. % bzgl. aller Bestandteile der Mischung, ganz besonders bevorzugt sind 10 - 25 Gew.%. Die Menge des zugegebenen Funktionalisierungsagens richtet sich nach dem gewünschten Grad der Funktionalisierung. Bei der Wahl des Funktionalisierungsgrades ist nur zu berücksichtigen, dass die Wasserlöslichkeit bzw. die Wasserdispergierbarkeit des funktionalisierten polymeren Bindemittels gewährleistet sein muss. Es ist dem Fachmann auf diesem Gebiete bekannt, welche Funktionalisierungsgrade für eine bestimmte gewünschte Anwendung erforderlich sind. Die Reaktion wird in der Regel unter Erwärmen durchgeführt. Die Temperatur wird so gewählt, dass eine mögliche Polymerisation der Funktionalisierungsagentien weitestgehend vermieden wird. In der Regel wird man daher Temperaturen von 150°C nicht überschreiten. Bevorzugt liegt die Reaktionstemperatur zwischen 60 und 120°C. Die Reaktionszeit, die sich nach dem gewünschten Funktionalisierungsgrad richtet, beträgt üblicherweise 1 - 20 h, bevorzugt 1- h.

Für die Durchführung der Reaktion sind keine besonderen Apparaturen erforderlich. Selbstverständlich wird man eine sehr gute Durchmischung des Reaktionsgutes gewährleisten. Die Durchführung kann in einfachen Rührkesseln mit Rührern ausreichender Leistungsfähigkeit, in heizbaren Mischern oder Knetapparaturen durchgeführt werden.

Das beschriebene Verfahren führt zu einer hervorragend gleichmässigen Funktionalisierung. Die Gleichmässigkeit der Funktionalisierung kann vom Fachmann z.B. mittels Raman-mapping bestimmt werden.

Die so erhaltene Zusammensetzung enthält vorzugsweise 50 - 90 Gew. % bzgl. der Summe aller Bestandteile eines wasserlöslichen oder in Wasser dispergierbaren polymeren organischen Bindmittels mit radikalisch polymerisierbaren Gruppen und 10 - 50 Gew. % des polaren, aprotischen Quellungsmittels, das mit dem Bindemittel verträglich ist. Die Zusammensetzung kann darüber hinaus noch Hilfsmittel wie bspw. Katalysatoren oder Stabilisatoren in geringen Mengen enthalten. Sie kann ausserdem noch nicht umgesetztes Funktionalisierungsagens enthalten, sowie Nebenprodukte wie Bestandteile des Funktionalisierungsagens, die im Zuge der Umsetzung abgespalten werden. Als ein Beispiel wäre hier Methacrylsäure zu erwähnen, die bei der Umsetzung von Methacrylsäureanhydrid mit Polyvinylalkohol in der Zusammensetzung verbleibt. Bevorzugt beträgt die Menge aller weiteren Bestandteile nicht mehr als 15 Gew.% bzgl. der Summe aller Bestandteile.

Bevorzugt ist die Zusammensetzung rieselfähig, was den Umgang mit dem Produkt stark vereinfacht.

Überraschenderweise wurde gefunden, dass die erfindungsgemässe Zusammensetzung ohne weitere Reinigung in hervorragender Weise zur Herstellung von strahlungsempfindlichen Aufzeichnungsmaterialien geeignet ist.

Als "strahlungsempfindlich" soll im Rahmen dieser Beschreibung jede Mischung oder Schicht verstanden werden, die durch aktinische, also chemisch wirksame Stahlung in ihren Eigenschaften, insbesondere in ihrer Löslichkeit, bleibend verändert wird. Als solche Strahlung wird bevorzugt kurzwelliges sichtbares oder langwelliges ultraviolettes Licht eingesetzt. Naturgemäss ist auch jede Strahlung höherer Energie, wie kurzwelliges UV-Licht, Elektronen-, Röntgen- oder γ-Strahlung, oder bei geeigneter Sensibilisierung auch längerwelliges Licht geeignet.

Wesentliches Merkmal des erfindungsgemässen, strahlungsempfindlichen Gemischs ist sein Gehalt an der oben definierten erfindungsgemässen Zusammensetzung.

Als Photoinitiatoren oder Photoinitiatorsysteme kommen die für strahlungsempfindliche Aufzeichnungsmaterialien allgemein üblichen in Frage, z.B. radikalliefernde Photoinitiatoren wie Benzoin oder Benzoinderivate, symmetrisch oder unsymmetrisch substituierte Benzilketale, wie Benzildimethylketal, Benzil-1-methyl-1-ethylketal, Diarylphosphinoxide, wie 2,4,6-Trimethyl-benzoyldiphenylphosphinoxid oder 2,6-Dimethoxy-benzoyldiphenylphosphinoxid, 2,4,6-Trimethyl-benzoylphenylphosphinsäureethylester oder Acyldiarylphosphinoxide, Diacylphosphinoxide oder substituierte und unsubstituierte Chinone, wie Ethylanthrachinon, Benzanthrachinon, Benzophenon oder 4,4'-Bis(dimethylamino)-benzophenon. Sie können allein oder im Gemisch mit Coinitiatoren verwendet werden, z.B. Ethylanthrachinon mit 4,4'-Bis(dimethylamino)-benzophenon oder Diacylphosphinoxide mit tertiären Aminen.

Die Photoinitiatoren sind in dem strahlungsempfindlichen Gemisch üblicherweise in Mengen von 0,1 bis 10, vorzugsweise 0,2 bis 5 Gew.% bzgl. der Summe aller Bestandteile enthalten.

Ausser der erfindungsgemässen Zusammensetzung und Photoinitiatoren können in dem strahlungsempfindlichen Gemisch weitere Hilfsund Zusatzstoffe, z.B. geeignete Farbstoffe, Pigmente oder photochrome Zusätze in einer Menge von 0,0001 - 2 Gew. % enthalten sein. Sie dienen der Steuerung der Belichtungseigenschaften, der Identifizierung, der direkten Kontrolle des Belichtungsergebnisses oder ästhetischen Zwecken. Voraussetzung für die Auswahl ist, dass sie die Photopolymerisation der Gemische nicht stören. Geeignet sind z.B. die löslichen Phenazinium-, Phenoxazinium-, Acridinium und Phenothiaziniumfarbstoffe, wie Neutralrot (C.I. 50040), Safranin T (C.I. 50240), Rhodanilblau, das Salz bzw. Amid aus Rhodamin D (Basic Violet 10, C.I 45170), Methylenblau B (C.I. 52015) oder auch Solvent Black 3 (C.I. 26150). Diese Farbstoffe können auch zusammen mit einer hinreichenden Menge eines Reduktionsmittels verwendet werden, welches den Farbstoff in Abwesenheit von aktinischen Licht nicht reduziert, bei Belichtung jedoch den Farbstoff im angeregten Elektronenzustand reduzieren kann. Beispiele solch milder Reduktionsmittel sind Ascorbinsäure, Anethol, Thioharnstoffe oder Hydroxylaminderivate, insbesondere Salze des N-Nitroso-cyclohexylhydroxylamins, vorzugsweise die Kalium-, Calcium- und Aluminiumsalze. Bewährt hat sich in vielen Fällen der Zusatz des 3- bis 10-fachen der Farbstoffmenge.

Ein besonderer Vorzug des erfindungsgemässen strahlungsempfindlichen Gemischs ist es, dass keine zusätzlichen photopolymerisierbaren, ethylenisch ungesättigte niedermolekulare oder oligomere Verbindungen zur Vernetzung zugegeben werden müssen. Es werden auch ohne diese Zusätze hervorragende Ergebnisse erzielt. Die vorliegende Erfindung umfasst aber gleichwohl strahlungsempfindliche Gemische, die photopolymerisierbare, ethylenisch ungesättigte niedermolekulare oder oligomere Verbindungen zusätzlich enthalten. Es kommen dabei solche Verbindungen in Frage, die für lichtempfindliche Aufzeichnungsmaterialien der in der Rede stehenden Art üblich und gebräuchlich sind und beispielsweise in der eingangs zitierten Literatur beschrieben sind. Die photopolymerisierbaren Verbindungen können dabei eine oder mehrere ethylenisch ungesättigte Doppelbindungen enthalten. Die Auswahl von Art und Menge richtet sich dabei einerseits nach dem beabsichtigten Verwendungszweck der lichtempfindlichen Zusammensetzung, z.B. nach der gewünschten Härte der daraus gebildeten Reliefformen, andererseits nach der Verträglichkeit mit dem polymeren Bindemittel und nach der Forderung nach Wasserentwickelbarkeit. Als Beispiele bevorzugter Verbindungen seien solche mit Hydroxylgruppen, Amidgruppen oder Polyethylenglykolstruktureinheiten genannt. Sehr geeignet sind auch Mono- und Polyacrylate und/oder -methacrylate von ein und mehrwertigen niedermolekularen Alkoholen. Beispielsweise können eingesetzt werden (Meth)acrylsäurester von Alkanolen mit 1 bis 20 Kohlenstoffatomen, wie Methylmethacrylat, Ethylacrylat, Propyl(meth)acrylat, Isopropyl(meth)acrylat; (Meth)acrylester mehrwertiger Alkohole mit 2 bis 20 Kohlenstoffatomen, z.B. 2-Hydroxy-ethyl(meth)acrylat, 2-Hydroxy-propyl(meth)acrylat, Ethylenglykoldi(meth)acrylat, Butandioldi(methacrylat) oder 1,1,1-Trimethylol-propantri(meth)acrylat, des weiteren Polyethylenglykolmono(meth)acrylat-monomethylether und 2-Diethylaminoethylacrylat. Geeignet sind auch Epoxid- und Urethan(meth)acrylate, wie sie z.B. durch Umsetzung von Bisphenol-A-diglycidylether mit (Meth)acrylsäure oder durch Umsetzung von Mono- oder Diisocyanaten mit Hydroxyalkyl(meth)acrylaten und ggf. mit hydroxylgruppenhaltigen Polyestern oder Polyethern erhalten werden können. Ebenso eignen sich Derivate des Acrylamids und des Methacrylamids, z.B. Ether ihrer N-Methylolderivate mit ein und mehrwertigen Alkoholen, wie z.B. Ethylenglykol, Glycerin, 1,1,1-Trimethylolpropan, oligomeren oder polymeren Ethylenoxidderivaten.

Das Mengenverhältnis von der erfindungsgemässen Zusammensetzung zu den zusätzlichen photopolymerisierbaren, ethylenisch ungesättigte niedermolekularen oder oligomeren Verbindungen im strahlungsempfindlichen Gemisch ist in weitem Umfang variierbar. Bevorzugt werden aber allenfalls geringe Mengen von bis zu 15 Gew.-% zugegeben.

Die strahlungsempfindliche Zusammensetzung kann des weiteren auch noch zusätzliche unmodifizierte wasserlösliche oder wasserdispergierbare Bindemittel enthalten. Geeignet sind dabei die bereits oben erwähnten unmodifizierten Polymere.

Die Herstellung des strahlungsempfindlichen Gemischs aus den einzelnen Bestandteilen kann in der üblichen Weise durch Mischen der Bestandteile mit oder ohne Lösungsmittel mit Hilfe bekannter Mischmethoden und durch Verarbeitung dieser Mischung zur strahlungsempfindlichen Schicht mit Hilfe bekannter Techniken, wie Giessen aus Lösung, Kalandrieren oder Extrudieren, erfolgen, wobei diese Maßnahmen auch in geeigneter Weise miteinander kombiniert werden können. Bevorzugt ist die Methode, die Bestandteile in Wasser oder einem wässrigen Lösungsmittelsystem zu rühren, bis eine homogene Lösung entstanden ist, die auf einen Träger vergossen werden kann. Die Stärke der Schicht beträgt zweckmässigerweise ca. 0,1 bis 2, insbesondere 0,2 - 1 mm.

Die strahlungsempfindliche Zusammensetzung kann bspw. zur Herstellung von Hoch- oder Reliefdruckformen, von Siebdruckbeschichtungsmaterialien oder auch von Folienprimern, d.h. Zusammensetzungen zur Vorbehandlung von Ink-Jet-Folien, um deren Bedruckbarkeit mit Tinten auf Wasserbasis zu gewährleisten, verwendet werden.

Die strahlungsempfindliche Schicht wird bei der erfindungsgemässen Hochdruckform gegebenenfalls mit einer Haftschicht auf einen dimensionsstabilen Träger aufgebracht. Beispiele geeigneter dimensionsstabiler Träger sind Platten, Folien sowie konische und Kupfer oder Nickel oder aus Kunststoffen wie Polyethylenterephthalat (PET), Polybutylenterephthalat, Polyamid, Polycarbonat, gegebenenfalls auch Gewebe und Vliese, wie Glasfasergewebe sowie Verbundmaterialien aus Glasfasern und Kunststoffen.

Als Haftschichten können unter anderem Polyurethanhaftlacke, z.B. gemäss DE-A-30 45 516 auf Basis von Polyisocyanatvernetzenden Polyether- oder Polyesterlacken in Schichtdicken zwischen 0,5 und 50, inbesondere zwischen 2 und 30 µm dienen.

Oberlackschichten können sich auf der von der Trägerschicht abgewandten Seite der Haftschicht befinden, weisen Schichtdicken zwischen 0,1 und 50, insbesondere 1 bis 10 µm auf und können z.B. aus verdünnter wässrig/-alkoholischer Lösung von teilverseiften Polyvinylestern, Phenylglycerinethermonoacrylat und Glyoxal, Beschichten, Trocknen und Einbrennen erhalten werden.

Auf der strahlungsempfindlichen Schicht befindet sich ggf. eine Deckschicht aus einem wasserlöslichen oder in Wasser dispergierbaren Polymeren, die immer dann benötigt wird, wenn die darunter befindliche wasser - oder wässrig/alkoholisch entwickelbare photopolymerisierbare Schicht so klebrig ist, dass beim Auflegen des fotografischen Negativs die vorhandenen Luft nicht gleichmässig entfernt werden kann und in der Folge sogenannte Vakuumfehler beim Belichten entstehen, oder aber dass sich das Negativ nicht mehr sauber von der Schichtoberfläche abtrennen lässt.

Die photopolymerisierbare Schicht kann gegen mechanische Beschädigungen durch eine Schutzfolie geschützt werden, die sich entweder auf der photographischen Schicht oder auf der Deckschicht befindet (vgl. z.B. Ullmanns Enzyclopedia of Industrial Chemistry, Band A 13, Seite 629).

Zur Entwicklung der erfindungsgemässen Hochdruckform kann die durch aktinisches Licht vernetzbare Schicht mit den für Photopolymerdruckplatten üblichen UV-Lichtquellen (Hauptemissionsbereich 320 - 400 nm) belichtet werden. Das Auswaschen unbelichteter Bereiche von Photodruckformen mit Wasser oder wässrigen Lösungsmittelsystemen, Nachspülen und Vortrocknen kann mit den für diesen Zweck handelsüblichen Auswaschsystemen durchgeführt werden.

Die folgenden Beispiele sollen die vorliegende Erfindung erläutern, ohne dass dadurch der Umfang der Erfindung eingeschränkt wird. Die Polyvinylalkohole werden wie üblich mit dem Verseifungsgrad und der Viskosität einer 4%igen Lösung in Wasser bei 20° charakterisiert.

### Herstellung der erfindungsgemäßen Zusammensetzungen:

### Beispiel 1

In einem Gefäß wird unter guter Durchmischung mittels eines leistungsstarken Rührers zu 800 Gewichtsteilen eines Polyvinylalkoholgranulats (Verseifungsgrad 82%, Viskosität: 5 mPas, Poval 405 der Fa. Kuraray, Japan) eine Mischung aus 80 Gewichtsteilen Propylencarbonat, 80 Gewichtsteilen Ethylencarbonat, 128 Gewichtsteilen Methacrylsäureanhydrid, 9 Gewichtsteilen eines Veresterungskatalysators (Methylimidazol) und 3 Gewichtsteilen 2,6-Di-t-butyl-kresol als thermischem Stabilisator (Kerobit® TBK der Fa. BASF, Deutschland) gegeben. Die Mischung wird anschließend bei einer Temperatur von 85° C 5 Stunden gerührt. Nach dieser Zeit erhält man ein rieselfähiges Granulat, das aus einem funktionalisierten Polyvinylalkohol, den Quellungsmitteln, Katalysator, Stabilisator und Methacrylsäure besteht.

### Beispiel 2

In einem Mischer wird unter guter Durchmischung zu 800 Gewichtsteilen eines Polyvinylalkoholgranulats (Verseifungsgrad 72%, Viskosität: 5 mPas, Alcotex® 72.5 der Fa. Harco, Großbritannien) eine Mischung aus 600 Gewichtsteilen Propylencarbonat, 100 Gewichtsteilen Methacrylsäureanhydrid, 6 Gewichtsteilen eines Veresterungskatalysators (Methylimidazol) und 3 Gewichtsteilen 2,6-Di-t-butyl-kresol als thermischem Stabilisator gegeben. Die Mischung wird anschließend bei einer Temperatur von 85° C 4 Stunden gemischt. Nach dieser Zeit erhält man ein Granulat, das aus einem funktionalisierten Polyvinylalkohol, dem Quellungsmittel, Katalysator, Stabilisator und Methacrylsäure besteht.

### Beispiel 3

In einem Mischer/Kneter werden unter guter Durchmischung zu 800 Gewichtsteilen eines Polyvinylalkoholgranulats (Verseifungsgrad 92%, Viskosität: 30 mPas, Mowiol® 30-92 der Fa. Clariant, Schweiz) eine Mischung aus 100 Gewichtsteilen Propylencarbonat, 100 Gewichtsteilen Ethylencarbonat, 200 Gewichtsteilen Methacrylsäureanhydrid, 10 Gewichtsteilen eines Veresterungskatalysators (Methylimidazol) und 3 Gewichtsteilen 2,6-Di-t-butyl-kresol gegeben. Die Mischung wird anschließend bei einer Temperatur von 85° C 5 Stunden gerührt. Nach dieser Zeit erhält man ein rieselfähiges Granulat, das aus einem funktionalisierten Polyvinylalkohol, den Quellungsmitteln, Katalysator, Stabilisator und Methacrylsäure besteht.

### Beispiel 4

In einem Gefäß werden unter guter Durchmischung mittels eines leistungsstarken Rührers zu 800 Gewichtsteilen eines Polyvinylalkoholgranulats (Verseifungsgrad 82%, Viskosität: 5 mPas, KP 405 der Fa. Kuraray, Japan) eine Mischung aus 200 Gewichtsteilen Dimethylcarbonat, 150 Gewichtsteilen Methacrylsäureanhydrid, 10 Gewichtsteilen eines Veresterungskatalysators (Methylimidazol) und 3 Gewichtsteilen 2,6-Di-t-butyl-kresol gegeben. Die Mischung wird anschließend bei einer Temperatur von 65° C 6 Stunden gerührt. Nach dieser Zeit erhält man ein rieselfähiges Granulat, das aus einem funktionalisierten Polyvinylalkohol, dem Quellungsmittel, Katalysator, Stabilisator und Methacrylsäure besteht.

### Beispiel 5

In einem Taumelmischer werden unter guter Durchmischung zu 800 Gewichtsteilen eines Terpolymeren aus Vinylpyrrolidon, Vinylacetat und Vinylalkohol (Vinylpyrrolidon/Vinylacetat-Copolymeres Luviskol® VA64 teilverseift, Molverhältnis ca. 60% zu 25% zu 15%) eine Mischung aus 80 Gewichtsteilen Propylencarbonat, 100 Gewichtsteilen Ethylencarbonat, 148 Gewichtsteilen Methacrylsäureanhydrid, 9 Gewichtsteilen eines Veresterungskatalysators (Methylimidazol) und 3 Gewichtsteilen 2,6-Di-t-butyl-kresol gegeben. Die Mischung wird anschließend bei einer Temperatur von 85° C 5 Stunden gerührt. Nach dieser Zeit erhält man ein rieselfähiges Pulver, das aus einem funktionalisierten Polymeren, den Quellungsmitteln, Katalysator, Stabilisator und Methacrylsäure besteht.

### Beispiel 6

In einem Gefäß werden unter guter Durchmischung mittels eines leistungsstarken Rührers zu 400 Gewichtsteilen eines Polyvinylalkoholgranulats (Verseifungsgrad 82%, Viskosität: 5 mPas, KP 405 der Fa. Kuraray, Japan) und 400 Gewichtsteilen eines Polyvinylalkohol-Polyethylenglykol-Copolymeren (Verseifungsgrad 97%, Viskosität: 5 mPas, Mowiol® GE 05-97, ehemals Hoechst AG, Deutschland) eine Mischung aus 80 Gewichtsteile Ethylencarbonat, 80 Gewichtsteilen Propylencarbonat, 148 Gewichtsteilen Methacrylsäureanhydrid, 9 Gewichtsteilen eines Veresterungskatalysators (Methylimidazol) und 3 Gewichtsteilen eines thermischen Stabilisators (z.B. Kerobit TBK der Fa. BASF, Deutschland) gegeben. Die Mischung wird anschließend bei einer Temperatur von 85° C 5 Stunden gerührt. Nach dieser Zeit erhält man ein rieselfähiges Granulat, das aus einem Gemisch von funktionalisierten Polyvinylalkoholen, den Quellungsmitteln, Katalysator, Stabilisator und Methacrylsäure besteht.

### Beispiel 7

In einem Taumelmischer werden unter guter Durchmischung zu 800 Gewichtsteilen eines Polyacrylsäurepulvers (M_{w}: 20000 g/mol, Fa. BASF, Deutschland) eine Mischung aus 100 Gewichtsteilen Propylencarbonat, 100 Gewichtsteilen Ethylencarbonat, 100 Gewichtsteilen Glycidylmethacrylat, 8 Gewichtsteilen eines Katalysators (z.B. Methylimidazol) und 3 Gewichtsteilen eines thermischen Stabilisators (z.B. Kerobit TBK der Fa. BASF, Deutschland) gegeben. Die Mischung wird anschließend bei einer Temperatur von 85° C 5 Stunden durchgemischt. Nach dieser Zeit erhält man ein Pulver, das aus einer funktionalisierten Polyacrylsäure, dem Quellungsmittel und Methacrylsäure besteht.

### Vergleichsbeispiel 1

In einem Gefäß werden unter guter Durchmischung mittels eines leistungsstarken Rührers zu 800 Gewichtsteilen eines Polyvinylalkoholgranulats (Verseifungsgrad 82%, Viskosität: 5 mPas, KP 405 der Fa. Kuraray, Japan) eine Mischung aus 160 Gewichtsteilen Methacrylsäureanhydrid, 8 Gewichtsteilen eines Veresterungskatalysators (Methylimidazol) und 3 Gewichtsteilen eines thermischen Stabilisators (z.B. Kerobit TBK der Fa. BASF, Deutschland) gegeben. Die Mischung wird anschließend bei einer Temperatur von 85° C 5 Stunden gerührt. Nach dieser Zeit erhält man ein rieselfähiges Granulat, das aus einem funktionalisierten Polyvinylalkohol, Katalysator, Stabilisator und Methacrylsäure besteht.

### Vergleichsbeispiel 2

Die Herstellung des modifizierten Polyvinylalkohols erfolgte gemäß DE-A-33 22 994. Dazu wurden 50 Gewichtsteile eines teilverseiften Polyvinylacetats (Verseifungsgrad 82 mol-%, mittleres Molekulargewcht 30 000) in 150 Gewichtsteilen Toluol aufgeschlämmt und dann mit 8 Gewichtsteilen Methacrylsäureanhydrid, 0,4 Gewichtsteilen Methylimidazol und 0,05 Gewichtsteilen Kerobit TBK versetzt. Das inhomogene Reaktionsgemisch wurde 5 h bei 85° C gerührt, danach das Umsetzungsprodukt abgetrennt, mit Toluol gewaschen und bei 50° C 12 Stunden im Trockenschrank getrocknet.

### Herstellung strahlungsempfindlicher Gemische, strahlungsempfindlicher Hochdruckformen und daraus hergestellter Hochdruckformen

### Beispiele 8 bis 13

Zur Herstellung von photopolymerisierbaren Druckformen wird mit den gemäß Beispiel 1 bis 6 erhaltenen Gemischen aus den jeweiligen funktionalisierten Polymeren, den Quellungsmitteln, Katalysator, Stabilisator und Methacrylsäure folgendermaßen verfahren.

470 Gewichtsteile des jeweiligen Gemisches werden in einer Mischung aus 318 Gewichtsteilen Wasser und 212 Gewichtsteilen n-Propanol bei einer Temperatur von 85° C solange gerührt, bis eine homogene Lösung entstanden ist. Anschließend werden 18 Gewichtsteile Benzildimethylketal und 3 Gewichtsteile des Kaliumsalzes von N-Nitroso-cyclohexylhydroxylamin zugegeben und das Gemisch bei 85° C gerührt, bis eine homogene Lösung entstanden ist. Diese Lösung wird dann auf einen 120 µm dicke Folie aus biaxial gerecktem und thermofixiertem Polyethylenterephthalat derart vergossen, daß sich nach dem Trocknen eine 540 µm dicke lichtempfindliche Schicht ergibt.

Auf die lichtempfindliche Schicht wird eine 10 µm dick mit einem Polyurethanhaftlack aus polyisocyanatvernetztem Polyether beschichtete 250 µm dicke Polyethylenterephthalatfolie kaschiert und die so erhaltene lichtempfindliche Druckplatte mit einer Gesamtdicke von 920 µm 3 Stunden bei 60° C in einem Trockenschrank getrocknet. Die lichtempfindliche Druckplatte wurde durch ein Testnegativ in einem handelsüblichen UV-Vakuumbelichter vom Format 80 x 107 cm belichtet (z.B. nyloprint®-Belichter 80 x 107) und in einem handelsüblichen Auswaschgerät (z.B. nyloprint® Auswaschsystem DW 85) mit Wasser entwickelt. Es wurden druckfertige flexible Hochdruckplatten mit sehr guten Zwischentiefen, spitzer Kopie und hervorragender Rißbeständigkeit erhalten.

Tabelle 1 führt die mit den erfindungsgemäss hergestellten Hochdruckformen erhaltenen Messdaten auf.

### Beispiel 14

329 Gewichtsteile des gemäß Beispiel 1 hergestellten Gemisches werden zusammen mit 94 Gewichtsteilen eines teilhydrolysierten Polyvinylalkohols (Poval® KP 405 der Fa. Kuraray, Japan) und 47 Gewichtsteilen eines Phenylglycidetheracrylats (Laromer® 8830 der Fa. BASF AG, Deutschland) in einer Mischung aus 318 Gewichtsteilen Wasser und 212 Gewichtsteilen n-Propanol bei einer Temperatur von 85° C solange gerührt, bis eine homogene Lösung entstanden ist. Anschließend werden 18 Gewichtsteile Benzildimethylketal und 3 Gewichtsteile des Kaliumsalzes von N-Nitroso-cyclohexylhydroxylamin zugegeben und das Gemisch bei 85° C gerührt, bis eine homogene Lösung entstanden ist. Diese Lösung wird dann auf einen 120 µm dicke Folie aus biaxial gerecktem und thermofixiertem Polyethylenterephthalat derart vergossen, daß sich nach dem Trocknen eine 540 µm dicke lichtempfindliche Schicht ergibt.

Für die Herstellung der Druckform wird wie in Beispielen 8- 13 beschrieben verfahren.

### Beispiel 15

80 Gewichtsteile des gemäß Beispiel 7 hergestellten Gemisches werden zusammen mit 240 Gewichtsteilen eines teilhydrolysierten Polyvinylalkohols (Poval® KP 405 der Fa. Kuraray, Japan) und 120 Gewichtsteilen eines Phenylglycidetheracrylats (Laromer® 8830 der Fa. BASF AG, Deutschland) in einer Mischung aus 360 Gewichtsteilen Wasser und 200 Gewichtsteilen n-Propanol bei einer Temperatur von 85° C solange gerührt, bis eine homogene Lösung entstanden ist. Anschließend werden 18 Gewichtsteile Benzildimethylketal und 3 Gewichtsteile des Kaliumsalzes von N-Nitroso-cyclohexylhydroxylamin zugegeben und das Gemisch bei 85° C gerührt, bis eine homogene Lösung entstanden ist. Diese Lösung wird dann auf einen 120 µm dicke Folie aus biaxial gerecktem und thermofixiertem Polyethylenterephthalat derart vergossen, daß sich nach dem Trocknen eine 540 µm dicke lichtempfindliche Schicht ergibt.

Für die Herstellung der Druckform wird wie in Beispielen 8 - 13 beschrieben verfahren.

### Vergleichsbeispiel 3

470 Gewichtsteile des gemäß Vergleichsbeispiel 1 hergestellten Gemisches werden in einer Mischung aus 318 Gewichtsteilen Wasser und 212 Gewichtsteilen n-Propanol bei einer Temperatur von 85° C gerührt. Selbst nach ca. 10 Stunden Lösezeit verbleiben noch gelartige Anteile im Gemisch, so daß keine homogene, für die Herstellung von Druckplatten geeignete Lösung hergestellt werden konnte.

### Vergleichsbeispiel 4

470 Gewichtsteile des Gemisches von Vergleichsversuch 2 werden in einer Mischung aus 318 Gewichtsteilen Wasser und 212 Gewichtsteilen n-Propanol bei einer Temperatur von 85° C solange gerührt, bis eine homogene Lösung entstanden ist. Anschließend werden 18 Gewichtsteile Benzildimethylketal, 3 Gewichtsteile des Kaliumsalzes von N-Nitroso-cyclohexylhydroxylamin und 0,03 Gewichtsteile Safranin T (C.I. 50240) zugegeben und das Gemisch bei 85° C gerührt, bis eine homogene Lösung entstanden ist. Diese Lösung wird dann auf einen 120 µm dicke Folie aus biaxial gerecktem und thermofixiertem Polyethylenterephthalat derart vergossen, daß sich nach dem Trocknen eine 540 µm dicke lichtempfindliche Schicht ergibt.

Für die Herstellung der Druckform wird wie in Beispielen 8 - 13 beschrieben verfahren.

Die Auswertung der belichteten und entwickelten Druckformen wurde optisch mittels Stereomikroskop und Bildanalysegerät durchgeführt. Die Druckeigenschaften wurden durch Andrucken von Testkli-schees mit einem DIN A 4-Motiv visuell beurteilt.

### Herstellung der erfindungsgemäßen Zusammensetzungen mit org. Phosphaten als Quellungsmitteln

### Beispiel 16

In einem Gefäß werden unter guter Durchmischung mittels eines leistungsstarken Rührers zu 800 Gewichtsteilen eines Polyvinylalkoholgranulats (Verseifungsgrad 82 %, Viskosität: 5 mPas, KP 405 der Fa. Kuraray, Japan) ein Gemisch aus 80 Gewichtsteilen Tris(2-Ethylhexyl)phosphat, 148 Gewichtsteilen Methacrylsäureanhydrid, 9 Gewichtsteilen eines Veresterungskatalysators (Methylimidazol) und 3 Gewichtsteilen eines thermischen Stabilisators (z.B. Kerobit TBK der Fa. BASF, Deutschland) gegeben. Die Mischung wird anschließend bei einer Temperatur von 85°C 5 Stunden gerührt. Nach dieser Zeit erhält man ein rieselfähiges Granulat, das aus einem Gemisch von funktionalisiertem Polyvinylalkohol, dem Quellungsmittel, Katalysator, Stabilisator und Methacrylsäure besteht.

### Beispiel 17

In einem Gefäß werden unter guter Durchmischung mittels eines leistungsstarken Rührers zu 800 Gewichtsteilen eines Polyvinylalkoholgranulats (Verseifungsgrad 82 %, Viskosität: 5 mPas, KP 405 der Fa. Kuraray, Japan) eine Mischung aus 80 Gewichtsteilen Tris(butoxyethyl)phosphats, 148 Gewichtsteilen Methacrylsäureanhydrid, 9 Gewichtsteilen eines Veresterungskatalysators (Methylimidazol) und 3 Gewichtsteilen eines thermischen Stabilisators (z.B. Kerobit TBK der Fa. BASF, Deutschland) gegeben. Die Mischung wird anschließend bei einer Temperatur von 85°C 5 Stunden durchgemischt. Nach dieser Zeit erhält man ein rieselfähiges Granulat, das aus einem Gemisch von funktionalisiertem Polyvinylalkohol, dem Quellungsmittel, Katalysator, Stabilisator und Methacrylsäure besteht.

### Beispiel 18

In einem Gefäß werden unter guter Durchmischung mittels eines leistungsstarken Rührers zu 800 Gewichtsteilen eines Polyvinylalkoholgranulats (Verseifungsgrad 82 %, Viskosität: 5 mPas, KP 405 der Fa. Kuraray, Japan) eine Mischung aus 40 Gewichtsteilen Tris(butoxyethyl)phosphats, 128 Gewichtsteilen Methacrylsäureanhydrid, 9 Gewichtsteilen eines Veresterungskatalysators (Methylimidazol) und 3 Gewichtsteilen eines thermischen Stabilisators (z.B. Kerobit TBK der Fa. BASF, Deutschland) gegeben. Die Mischung wird anschließend bei einer Temperatur von 85°C 5 Stunden durchgemischt. Nach dieser Zeit erhält man ein rieselfähiges Granulat, das aus einem Gemisch von funktionalisiertem Polyvinylalkohol, dem Quellungsmittel, Katalysator, Stabilisator und Methacrylsäure besteht.

### Herstellung strahlungsempfindlicher Gemische, strahlungsempfindlicher Hochdruckformen und daraus hergestellter Hochdruckformen

### Beispiele 19 bis 21

Zur Herstellung von photopolymerisierbaren Druckformen wird mit den gemäß Beispiel 16 bis 18 erhaltenen Gemischen aus den jeweiligen funktionalisierten Polymeren, den Quellungsmitteln, Katalysator, Stabilisator und Methacrylsäure wie in Beispiel 14 verfahren. Für die Herstellung der Druckform wird wie in den Beispielen 8-13 verfahren.

Tabelle 1 führt die mit den erfindungsgemäßen Hochdruckformen erhaltenen Meßdaten auf.

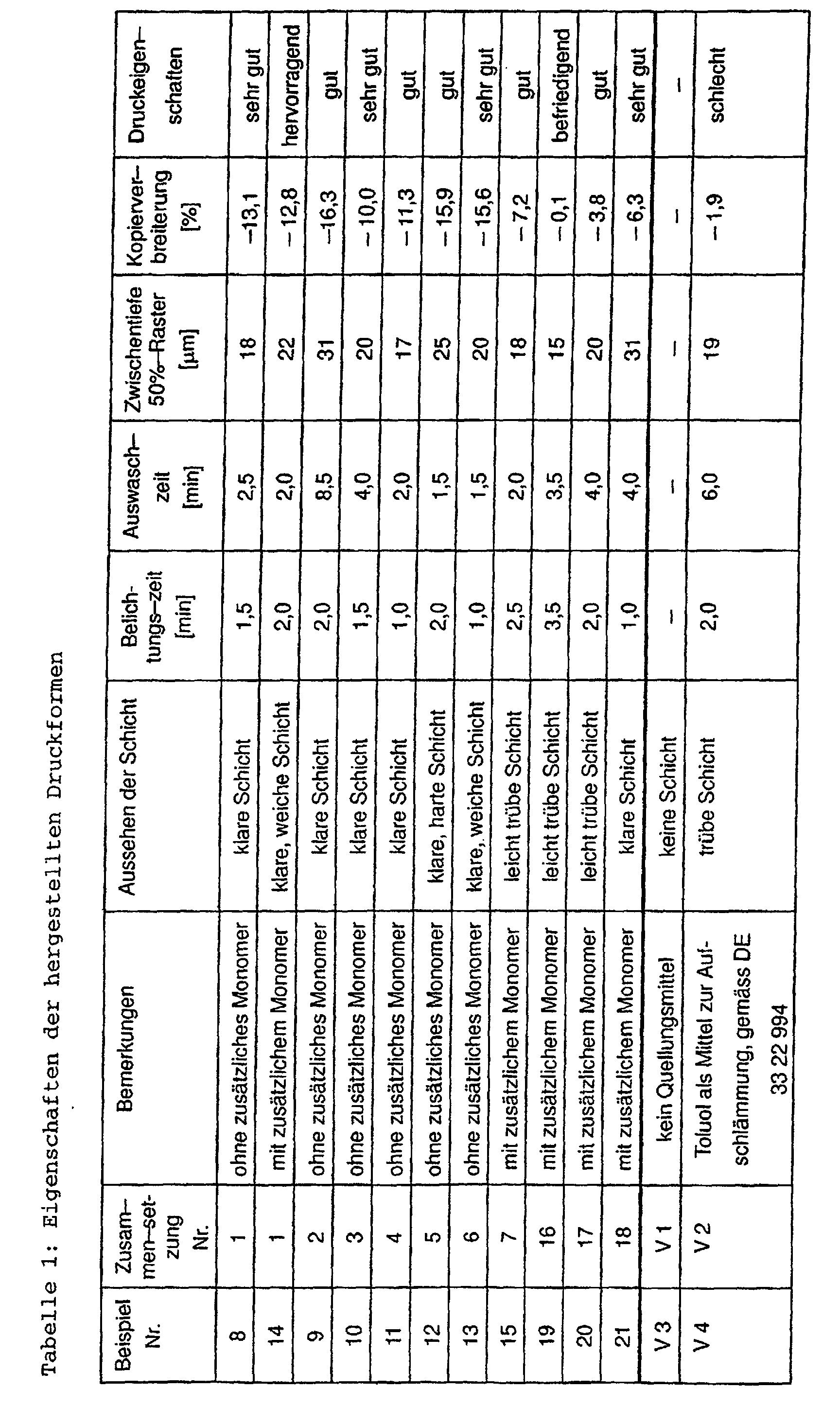

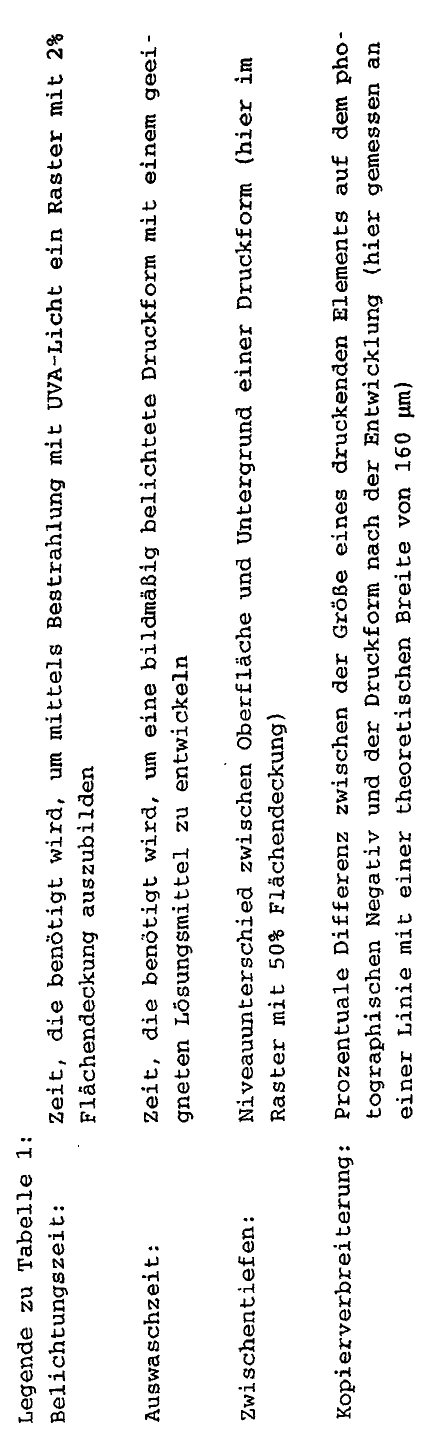

## Patentansprüche

1. Verfahren zur Herstellung vernetzbarer wasserlöslicher oder wasserdispergierbarer Zusammensetzungen, **dadurch gekennzeichnet, dass** man ein unmodifiziertes, wasserlösliches oder in Wasser dispergierbares polymeres Bindemittel, ausgewählt aus der Gruppe von Polyvinylalkohol, Polyvinylalkohol-Copolymeren, Poly(meth)acrylsäure, Poly(meth)acrylsäure-Copolymeren, Polyvinylamin, Polyvinylamin Copolymeren, in Gegenwart von einem oder mehreren polaren aprotischen Quellungsmitteln, die mit dem Bindemittel verträglich sind, ausgewählt aus der Gruppe aus einem oder mehreren organischen Carbonaten, einem oder mehreren organischen Phosphaten oder Gemischen davon, unter Vermischung mit einer oder mehreren Verbindungen umsetzt, wobei diese Verbindungen vernetzbare Gruppen sowie Gruppen, die mit dem polymeren Bindemittel reagieren können, aufweisen.

2. Verfahren zur Herstellung einer Zusammensetzung gemäß Anspruch 1, **dadurch gekennzeichnet, dass** die Menge des Quellungsmittels 10-50 Gew.-% beträgt.

3. Zusammensetzung, enthaltend
(a) 50-90 Gew.-% eines wasserlöslichen oder in Wasser dispergierbaren polymeren Bindemittels mit radikalisch polymerisierbaren Gruppen, ausgewählt aus der Gruppe von modifizierten Polyvinylalkoholen, modifizierten Polyvinylalkohol-Copolymeren, modifizierten Poly(meth)acrylsäuren, modifizierte Poly(meth)acrylsäure-Copolymeren, modifizierten Polyvinylamin, modifizierten Polyvinylamin-Copolymeren oder Mischungen von zwei oder mehreren davon, und
(b) 10-50 Gew.-% eines polaren, aprotischen Quellungsmittels, das mit dem Bindemittel (a) verträglich ist, ausgewählt aus der Gruppe von aus einem oder mehreren organischen Carbonaten, einem oder mehreren organischen Phosphaten oder Gemischen davon.

4. Zusammensetzung gemäß Anspruch 3, **dadurch gekennzeichnet, dass** es sich bei den organischen Carbonaten um Ethylencarbonat, Propylencarbonat, Butylencarbonat, Dimethylcarbonat oder Mischungen davon handelt.

5. Zusammensetzung gemäß Anspruch 3, **dadurch gekennzeichnet, dass** es sich bei den organischen Phosphaten um Tris(2-Ethylhexyl)phosphat handelt.

6. Zusammensetzung gemäß den Ansprüchen 3 bis 5, **dadurch gekennzeichnet, dass** die Zusammensetzung rieselfähig ist.

7. Strahlungsempfindliches Gemisch enthaltend
(a) eine Zusammensetzung gemäß einem der Ansprüche 3 bis 6,
(b) mindestens einen Photopolymerisationsinitiator sowie gegebenenfalls
(c) weitere übliche Zusatz- und/oder Hilfsstoffe.

8. Strahlungsempfindliches Gemisch gemäß Anspruch 7, **dadurch gekennzeichnet, dass** es weitere wasserlösliche oder in Wasser dispergierbare polymere organische Bindemittel enthält.

9. Strahlungsempfindliches Gemisch gemäß Anspruch 7 oder 8 **dadurch gekennzeichnet, dass** es zusätzlich eine oder mehrere ethylenisch ungesättigte, photopolymerisierbare niedermolekulare oder oligomere Verbindungen enthält.

10. Verwendung eines strahlungsempfindlichen Gemischs gemäß Ansprüchen 7 bis 9 zur Herstellung einer strahlungsempfindlichen Hochdruckform, eines Siebdruckbeschichtungsmaterials oder eines Folienprimers.

11. Strahlungsempfindliche Hochdruckform mit einem dimensionsbeständigen Schichtträger und einer strahlungsempfindlichen Schicht, die aus einem Gemisch gemäß den Ansprüchen 7 bis 9 besteht.

12. Strahlungsempfindliche Hochdruckform nach Anspruch 11, **dadurch gekennzeichnet, dass** sie auf der strahlungsempfindlichen Schicht eine wasserlösliche oder in Wasser dispergierbare Deckschicht trägt.

13. Strahlungsempfindliche Hochdruckform nach Anspruch 11 oder 12, **dadurch gekennzeichnet, dass** sie auf ihrer Oberfläche eine abziehbare Deckfolie trägt.

14. Verfahren zum Herstellen einer Hochdruckform, **dadurch gekennzeichnet, dass** man eine strahlungsempfindliche Hochdruckform nach einem der Ansprüche 11-13 bildmäßig mit aktinischer Strahlung bestrahlt, ggf. die Deckfolie vor oder nach dem Bestahlen abzieht und die unbestrahlten Bereiche der strahlungsempfindlichen Schicht, ggf. zusammen mit der transparenten Deckschicht, mit Wasser oder einer wässrigen Lösung auswäscht.

## Claims

1. A process for the preparation of crosslinkable water-soluble or water-dispersible compositions, wherein an unmodified water-soluble or water-dispersible polymeric binder selected from the group consisting of polyvinyl alcohol, polyvinyl alcohol copolymers, poly(meth)acrylic acid, poly(meth)acrylic acid copolymers, polyvinylamine and polyvinylamine copolymers, is reacted in the presence of one or more polar aprotic swelling agents which are compatible with the binder and are selected from the group consisting of one or more organic carbonates, one or more organic phosphates and mixtures thereof, with mixing with one or more compounds, these compounds having crosslinkable groups and groups which are capable of reacting with the polymeric binder.

2. A process for the preparation of a composition as claimed in claim 1, wherein the amount of the swelling agent is 10-50% by weight.

3. A composition containing
(a) 50 - 90% by weight of a water-soluble or water-dispersible polymeric binder having groups capable of free radical polymerization, selected from the group consisting of modified polyvinyl alcohols, modified polyvinyl alcohol copolymers, modified poly(meth)acrylic acids, modified poly(meth)acrylic acid copolymers, modified polyvinylamine, modified polyvinylamine copolymers and mixtures of two or more thereof, and
(b) 10 - 50% by weight of a polar, aprotic swelling agent which is compatible with the binder (a) and is selected from the group consisting of one or more organic carbonates, one or more organic phosphates and mixtures thereof.

4. A composition as claimed in claim 3, wherein the organic carbonate is ethylene carbonate, propylene carbonate, butylene carbonate, dimethyl carbonate or a mixture thereof.

5. A composition as claimed in claim 3, wherein the organic phosphate is tris(2-ethylhexyl) phosphate.

6. A composition as claimed in any of claims 3 to 5, wherein the composition is free-flowing.

7. A radiation-sensitive mixture containing
(a) a composition as claimed in any of claims 3 to 6,
(b) at least one photopolymerization initiator and, if required,
(c) further conventional additives and/or assistants.

8. A radiation-sensitive mixture as claimed in claim 7, which contains further water-soluble or water-dispersible polymeric organic binders.

9. A radiation-sensitive mixture as claimed in claim 7 or 8, which additionally contains one or more ethylenically unsaturated, photopolymerizable low molecular weight or oligomeric compounds.

10. Use of a radiation-sensitive mixture as claimed in any of claims 7 to 9 for the production of a radiation-sensitive letterpress printing plate, of a coating material for screen printing or of a film primer.

11. A radiation-sensitive letterpress printing plate having a dimensionally stable substrate and a radiation-sensitive layer which consists of a mixture as claimed in any of claims 7 to 9.

12. A radiation-sensitive letterpress printing plate as claimed in claim 11, which carries a water-soluble or water-dispersible release layer on the radiation-sensitive layer.

13. A radiation-sensitive letterpress printing plate as claimed in claim 11 or 12, which carries a peelable cover sheet on its surface.

14. A process for the production of a letterpress printing plate, wherein a radiation-sensitive letterpress printing plate as claimed in any of claims 11 - 13 is exposed imagewise to actinic radiation, if required the cover sheet is peeled off before or after exposure and the unexposed parts of the radiation-sensitive layer are washed out with water or an aqueous solution, if necessary together with the transparent release layer.

## Revendications

1. Procédé de préparation de compositions réticulables, solubles ou dispersibles dans l'eau, **caractérisé en ce qu'**on fait réagir en le mélangeant à un ou plusieurs composés un liant polymère non modifié, soluble ou dispersible dans l'eau, choisi dans l'ensemble comprenant le poly(alcool vinylique), les copolymères de l'alcool vinylique, le poly(acide(méth)acrylique), les copolymères de l'acide (méth)acrylique, la polyvinylamine, les copolymères de vinylamine, en présence d'un ou plusieurs agents gonflants aprotiques polaires compatibles avec le liant, choisis dans l'ensemble comprenant un ou plusieurs carbonates organiques, un ou plusieurs phosphates organiques ou des mélanges de ceux-ci, ces composés comportant des groupes réticulables, ainsi que des groupes à même de réagir avec le liant polymère.

2. Procédé de préparation d'une composition selon la revendication 1, **caractérisé en ce que** la quantité de l'agent gonflant est de 10 à 50 % en poids.

3. Composition contenant
(a) de 50 à 90 % en poids d'un liant polymère soluble ou dispersible dans l'eau, comportant des groupes polymérisables par polymérisation radicalaire, choisi dans l'ensemble comprenant les poly(alcools vinyliques) modifiés, les copolymères de l'alcool vinylique modifiés, les poly(acide(méth)acryliques) modifiés, les copolymères de l'acide (méth)acrylique modifié, la polyvinylamine modifiée, les copolymères de la vinylamine modifiée ou les mélanges d'au moins deux d'entre eux, et
(b) de 10 à 50 % en poids d'un agent gonflant aprotique polaire compatible avec le liant (a), choisi dans l'ensemble comprenant un ou plusieurs carbonates organiques, un ou plusieurs phosphates organiques ou des mélanges de ceux-ci.

4. Composition selon la revendication 3, **caractérisée en ce que**, pour ce qui concerne les carbonates organiques, il s'agit de carbonate d'éthylène, de carbonate de propylène, de carbonate de butylène, de carbonate de diméthyle ou de mélange de ceux-ci.

5. Composition selon la revendication 3, **caractérisée en ce que**, pour ce qui concerne les phosphates organiques, il s'agit du phosphate de tris(2-éthylhexyle).

6. Composition selon les revendications 3 à 5, **caractérisée en ce que** la composition est à écoulement libre.

7. Mélange sensible au rayonnement, contenant
(a) une composition selon l'une des revendications 3 à 6,
(b) au moins un amorceur de photopolymérisation, et éventuellement
(c) d'autres additifs et/ou adjuvants usuels.

8. Mélange sensible au rayonnement selon la revendication 7, **caractérisé en ce qu'**il contient d'autres liants organiques polymères solubles ou dispersibles dans l'eau.

9. Mélange sensible au rayonnement selon la revendication 7 ou 8, **caractérisé en ce qu'**il contient en outre un ou plusieurs composés photopolymérisables à insaturation éthylénique, à faible masse moléculaire ou oligomères.

10. Utilisation d'un mélange sensible au rayonnement selon les revendications 7 à 9 pour préparer une forme d'impression typographique sensible au rayonnement, un matériau de revêtement pour impression sérigraphique, ou une couche primaire pour feuilles.

11. Forme d'impression typographique sensible au rayonnement, avec un support d'émulsion dimensionnellement stable et une couche sensible au rayonnement qui est constituée d'un mélange selon les revendications 7 à 9.

12. Forme d'impression typographique sensible au rayonnement selon la revendication 11, **caractérisée en ce qu'**elle porte sur la couche sensible au rayonnement une couche de finition soluble ou dispersible dans l'eau.

13. Forme d'impression typographique sensible au rayonnement selon la revendication 11 ou 12, **caractérisée en ce qu'**elle porte sur sa surface une feuille de finition pelliculable.

14. Procédé de fabrication d'une forme d'impression typographique, **caractérisé en ce qu'**on expose selon l'image à un rayonnement actinique une forme d'impression typographique sensible au rayonnement selon l'une des revendications 11 à 13, on enlève éventuellement par pelage la feuille de finition avant ou après cette exposition, et on élimine par lavage avec de l'eau ou une solution aqueuse les zones non exposées de la couche sensible au rayonnement, éventuellement en même temps que la couche de finition transparente.
